# FASCICULE DE BREVET EUROPEEN

(11) **EP 2 677 549 B1**
(45) Date de publication et mention de la délivrance du brevet: **30.08.2017**
(21) Numéro de dépôt: 13172505.3
(22) Date de dépôt: 18.06.2013
(51) Int. Cl.: H01L 31/0352, H01L 31/105

(54) **Récepteur optique semi-conducteur à structure PIN**
Optischer Halbleiterempfänger mit PIN-Struktur
Semiconductor optical receiver with PIN structure

(30) Priorité: 20.06.2012 FR 1255772
(43) Date de publication de la demande: 25.12.2013
(73) Titulaire: Commissariat à l'Énergie Atomique et aux Énergies Alternatives, 75015 Paris (FR)
(72) Inventeur: Kopp, Christophe, 38120 Fontanil-Cornillion (FR); Fedeli, Jean-Marc, 38120 Saint Egreve (FR); Menezo, Sylvie, 38500 Voiron (FR)
(74) Mandataire: Croonenbroek, Thomas Jakob

(56) Documents cités:
- EP-A2- 0 314 372
- US-A1- 2005 173 712
- US-A1- 2008 265 357

## Description

La présente invention concerne un récepteur optique semi-conducteur à structure PIN, qui peut être utilisé notamment pour la transmission optique de données à haut débit.

Des communications par fibre optique utilisent généralement des sources de lumière modulées, comme un laser, un récepteur optique, notamment une photodiode et une fibre optique reliant la source de lumière et le récepteur optique. Dans ce contexte, le laser émet des impulsions porteuses des données à transporter et qui seront reçues par le récepteur qui convertit ces signaux optiques en signaux électriques.

Généralement, on utilise des photodiodes à structure PIN qui comprennent en particulier trois couches : une couche de contact électrique dopé p, une couche de contact électrique dopé n et une couche intrinsèque disposée entre les deux couches.

Les couches de contact électrique dopées respectivement p et n sont reliées à des contacts métalliques réalisés sous forme d'anneau.

La couche intrinsèque est réalisée sous forme de plot, par exemple en Germanium, (ce plot est également appelé MESA dans la littérature) qui absorbe la lumière incidente pour la transformer en photocourant ou courant électrique.

Typiquement, un tel plot possède une forme cylindrique à section transversale circulaire et possède un diamètre supérieur à 10µm afin de s'adapter aux dimensions du faisceau incident généralement issu d'une fibre optique.

L'anneau métallique formant le contact métallique en contact avec la couche de contact électrique supérieure est généralement de diamètre inférieur au diamètre du plot. Le métal étant opaque aux longueurs d'onde considérées (proche infrarouge : 850nm à 1600nm), cet anneau masque donc une partie de la lumière incidente, ce qui diminue la performance / sensibilité de la photodiode.

Pour augmenter la performance d'une telle photodiode, on pourrait envisager d'augmenter le diamètre du plot de la couche intrinsèque.

Or, il est important que le diamètre du plot reste faible, car il définit la capacité de la photodiode et donc sa bande passante.

Plus le diamètre du plot est petit, plus la capacité de la photodiode est petite, plus la bande passante de la photodiode est grande.

Il serait donc nécessaire de marier deux exigences antagonistes à savoir d'une part minimiser le diamètre du MESA afin d'optimiser la bande passante de la photodiode et d'autre part maximiser le diamètre de l'anneau du contact métallique afin d'optimiser la sensibilité de la photodiode.

Cette problématique apparaît particulièrement avec l'augmentation de la bande passante à plus 10GHz (i.e. 25GHz, 40GHz) alors que le diamètre du faisceau qui éclaire la photodiode reste constant à ∅10-12µm imposé par le standard sur les fibres monomodes pour les applications de télécommunication optique.

Une solution pour résoudre partiellement ce problème a été proposé dans le document US2008/0265357.

Comme on le voit notamment sur la figure 3 de ce document, la couche de contact électrique supérieure possède un diamètre plus grand que la couche intrinsèque, ce qui permet d'avoir un anneau métallique de diamètre plus important ne masquant plus une partie du plot de la couche intrinsèque.

Si effectivement, la performance /sensibilité d'une telle structure de photodiode est améliorée tout en gardant une bande passante importante, cette approche néglige l'apparition d'une capacité parasite qui s'ajoute à la capacité du plot de la couche intrinsèque et qui a tendance de limiter la bande passante de la photodiode.

La présente invention vise à pallier ces inconvénients précités, au moins en partie.
A cet effet, la présente invention propose un récepteur optique semi-conducteur à structure PIN comprenant comme couches de semiconducteur une première couche de contact et une seconde couche de contact ainsi qu'une couche intrinsèque sous forme de plot disposée entre la première couche de contact électrique et la seconde couche de contact électrique, les première et seconde couches de contact ayant dans un plan perpendiculaire à l'axe du plot des dimensions supérieures à la section transversale du plot, caractérisé en que la première et la seconde couche de contact électrique présentent respectivement une étendue allongée et sont décalés angulairement l'une par rapport à l'autre pour minimiser les surfaces en regard des deux couches de contact électrique.

En effet, la capacité parasite est proportionnelle à la surface en regard des deux couches de contact électrique. Selon les caractéristiques ci-dessus, on arrive donc à minimiser cette surface en regard et limiter ainsi les effets de la capacité parasite.

Le récepteur optique semi-conducteur peut en outre comporter les caractéristiques suivantes seules ou en combinaison :
Selon un mode de réalisation, la première couche de contact électrique présente une forme rectangulaire.
Selon un autre mode de réalisation la première couche de contact électrique présente une forme rectangulaire arrondie.
La deuxième couche de contact peut présenter une forme rectangulaire, voir une forme rectangulaire arrondie.
Alternativement la deuxième couche de contact peut présenter une forme circulaire centrale avec des lobes latéraux.
On peut prévoir par exemple que la forme circulaire centrale de la deuxième couche de contact possède un diamètre légèrement supérieur au diamètre du plot.
Le décalage des axes longitudinaux des deux couches de contact peut être de 90°.
Selon un aspect, la couche intrinsèque est réalisée en Germanium, en InGaAs ou en InP.
Selon un autre aspect, la couche intrinsèque possède une épaisseur comprise entre 1µm et 2µm.
Le plot de la couche intrinsèque possède par exemple une forme cylindrique ou une forme tronconique.
L'épaisseur des couches de contact électrique peut être comprise entre 200nm et 600nm.
Les couches de contact électrique sont par exemple réalisées en silicium dopé, en InGaAs dopé ou en InP dopé.

D'autres avantages et caractéristiques apparaîtront à la lecture de la description de l'invention, ainsi que des figures suivantes sur lesquelles :
- la figure 1 montre une vue schématique en coupe transversale selon la ligne I-I des figures 2 et 3 du récepteur optique semi-conducteur,
- la figure 2 montre une vue schématique des contours des certaines couches de semi-conducteurs superposées selon un premier mode de réalisation,
- la figure 3 montre une vue schématique des contours des certaines couches de semi-conducteurs superposées selon un second mode de réalisation, et
- et les figures 4 à 8 montrent un exemple des étapes d'un procédé de fabrication d'un récepteur optique semi-conducteur selon l'invention selon des vues schématiques en coupe transversale.

Sur toutes les figures, les éléments identiques portent les mêmes numéros de référence.

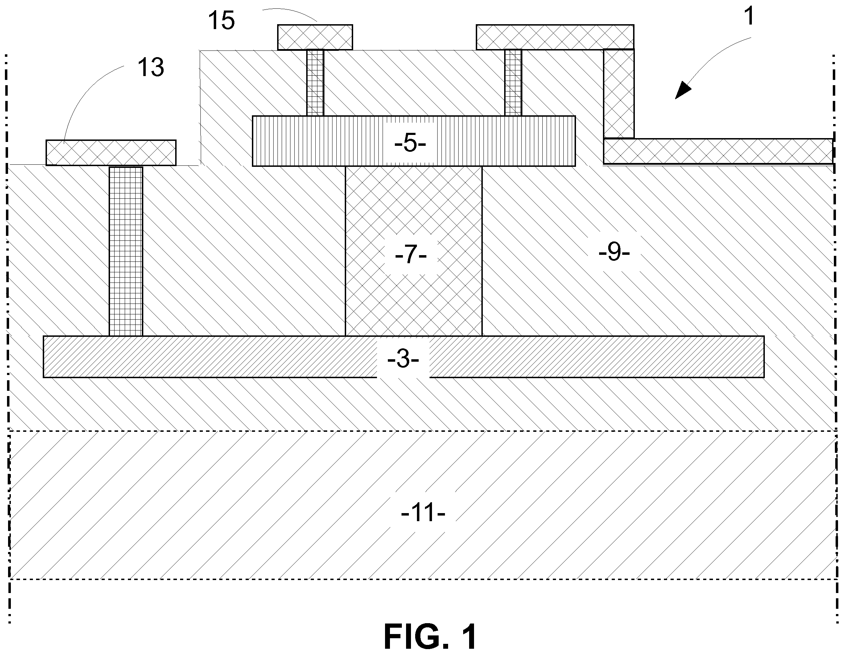

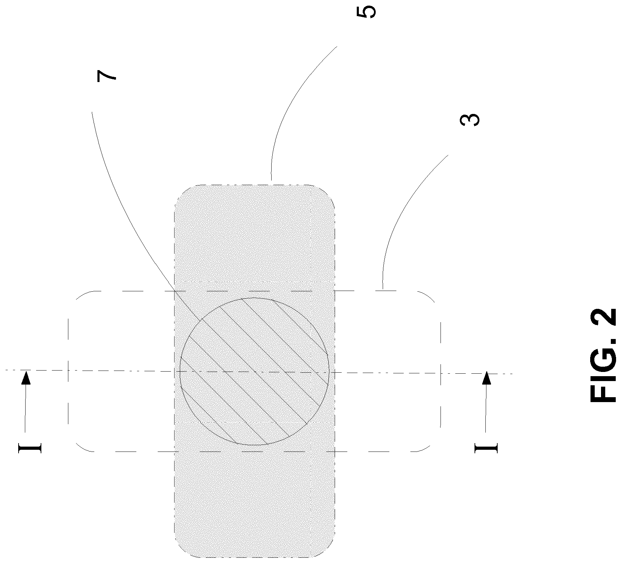

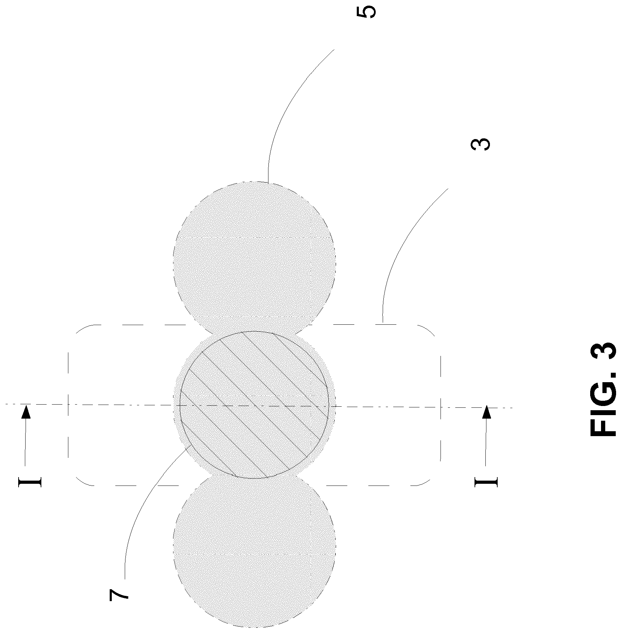

La figure 1 présente une vue schématique en coupe transversale selon la ligne I-I des figures 2 et 3 d'un récepteur optique semi-conducteur à structure PIN 1.

Ce récepteur optique semi-conducteur à structure PIN 1 comprend une première couche de contact 3 (couche de contact inférieure sur la figure), une seconde couche de contact 5 (couche de contact supérieure sur la figure) ainsi qu'une couche intrinsèque 7 sous forme de plot disposée entre la première couche de contact électrique 3 et la seconde couche de contact électrique 5.

La couche intrinsèque 7 est par exemple réalisée en Germanium, en InGaAs ou en InP et possède une épaisseur comprise entre 1µm et 2µm.

Comme on le voit sur la figure, la couche intrinsèque 7 possède une forme cylindrique.

Selon une variante non représentée, le plot de la couche intrinsèque peut aussi posséder une forme tronconique.

Les couches de contact électrique sont par exemple réalisées en silicium dopé, en InGaAs dopé ou en InP dopé, bien entendu une couche dopée p+ et l'autre dopée n+.

Par exemple, la couche 3 est réalisée en Si dopé p+, tandis que la couche 5 est réalisée en Si dopé n+.

L'épaisseur des couches de contact électrique est comprise dans la plage de 200nm et 600nm.

Comme on le voit sur la figure 1, les première et seconde couches de contact 3, 5 ont dans un plan perpendiculaire à l'axe du plot 7 des dimensions supérieures à la section transversale du plot, mais on reviendra sur ce point plus en détail.

De plus, cet ensemble des couches 3 ,5 et 7 est entouré de l'oxyde 9 servant de passivation, par exemple de SiO₂, ou de SiN ou encore un mélange de SiO₂ et de SiN et repose sur une couche de substrat 11.

Des ouvertures ont été ménagées dans la couche d'oxyde de passivation 9 pour la réalisation de contacts métalliques 13 et 15, le contact métallique 15 étant réalisé sous forme d'anneau métallique, comme cela a été décrit dans l'introduction ci-dessus, mais avec la différence que le diamètre de l'anneau est supérieur au diamètre du plot de la couche intrinsèque 7, ce qui permet d'avoir une meilleure sensibilité du récepteur optique 1.

La figure 2 montre une vue schématique de dessus des contours des certaines couches de semi-conducteurs superposées selon un premier mode de réalisation, plus précisément les couches de contact électrique 3 et 5 et la couche intrinsèque 7 en forme de plot.

La première couche de contact électrique 3, la couche inférieure, est représentée par un contour en tirets et pointillés.

La seconde couche de contact électrique 5, la couche supérieure, est représentée par un contour en tirets.

La seconde couche intrinsèque 7 est représentée par un cercle hachuré.

Ainsi que l'on voit sur cette figure 2, la première et la seconde couche de contact électrique présentent respectivement une étendue allongée et sont décalés angulairement l'une par rapport à l'autre pour minimiser les surfaces en regard des deux couches de contact électrique 3 et 5.

En effet, les inventeurs de la présente demande ont identifié une capacité parasite introduite par l'oxyde 9 autour du plot 7 qui peut dégrader la bande passante totale du récepteur optique 1. Cette capacité parasite est proportionnelle à la face en regard les deux couches de contacts électrique 3 et 5.

Ainsi donc, pour minimiser, vue de dessus, la superposition de ces deux couches tout en bénéficiant d'une sensibilité accrue et d'une bande passante importante, les deux couches de contact 3 et 5 présentent une forme allongée et sont décalées, ici de 90° l'une par rapport à l'autre.

Sur la figure 2, la première et la deuxième couches 3 et 5 de contact présentent une forme rectangulaire, plus précisément une forme rectangulaire arrondie. Mais on peut aussi par exemple envisager une forme elliptique sans sortir du cadre de la présente invention.

Pour ce mode de réalisation, la largeur des rectangles est légèrement supérieure au diamètre du plot de la couche intrinsèque 7.

La figure 3 montre une vue similaire à celle de la figure 2 d'un autre mode de réalisation.

Sur cette figure la première couche de contact 3 présente une forme rectangulaire, plus précisément rectangulaire arrondie, tandis que la deuxième couche de contact présente une forme circulaire centrale avec des lobes latéraux, ce qui permet de minimiser davantage la surface en regard des deux couches de contact 3 et 5.

La forme circulaire centrale de la couche 5 possède un diamètre légèrement supérieur au diamètre du plot 7.

On comprend donc que l'invention permet de réduire la capacité parasite d'oxyde ce qui permet d'améliorer la bande passante du récepteur optique selon l'invention.

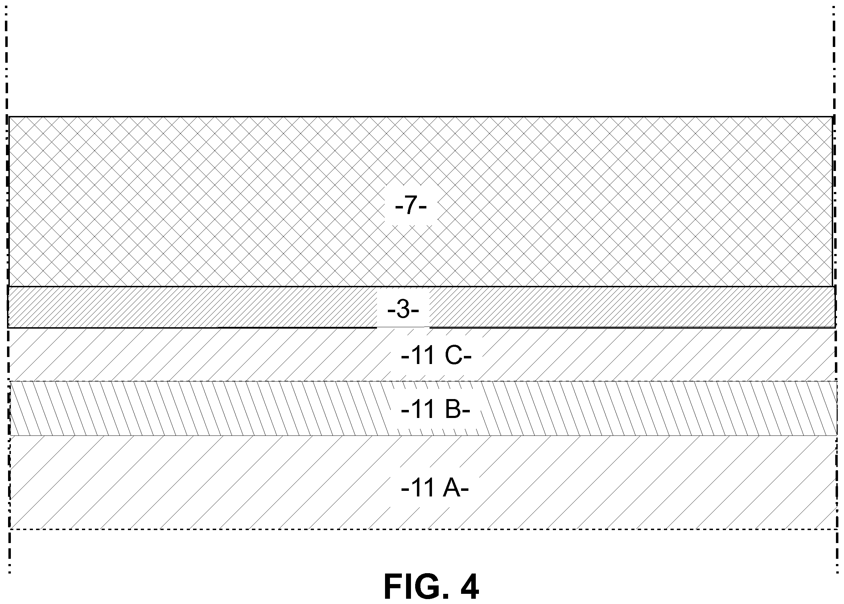

Les figures 4 à 8 montrent un exemple des étapes d'un procédé de fabrication d'un récepteur optique semi-conducteur selon l'invention selon des vues schématiques en coupe transversale.

Par rapport à la figure 1, on peut observer que la couche de substrat 11 est réalisée dans cet exemple de réalisation par trois couches superposées, une couche de substrat CMOS 11A, une couche 11B d'oxyde enterré (BOX - ou « burried oxyde» en anglais) et une couche de silicium 11C.

Sur la figure 4 est représentée une première étape de fabrication du récepteur optique semi-conducteur. Lors de cette étape, on dépose sur la couche de silicium 11C, par exemple par épitaxie pleine plaque, une couche de silicium dopé p+ d'une épaisseur d'environ 200nm qui formera sur le produit fini la couche de contact électrique 3 et une couche de Germanium d'une épaisseur d'environ 1,3µm qui formera sur le produit fini la couche intrinsèque 7, le plot.

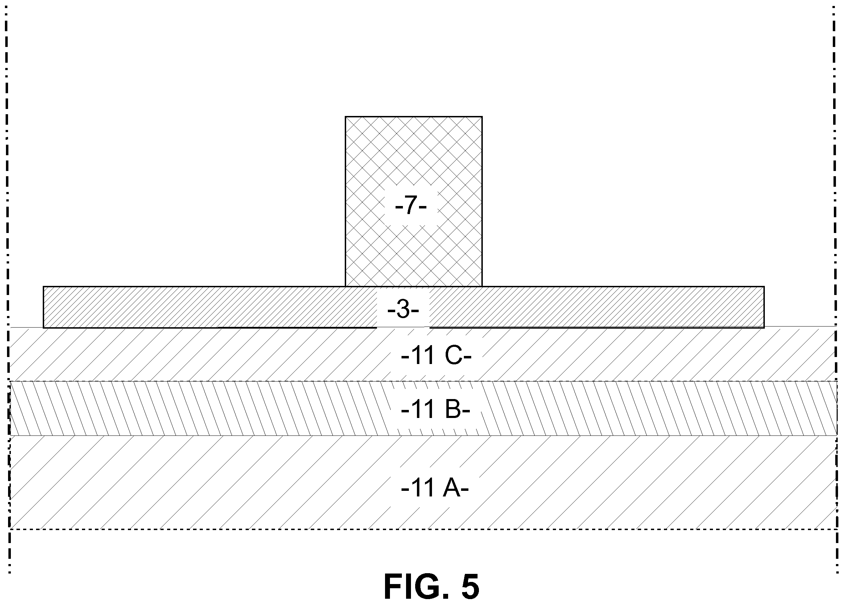

Selon une seconde étape représentée sur la figure 5, on enlève le surplus périphérique de Germanium et de silicium dopé p+, par exemple par lithographie et gravure, pour former d'une part le plot de la couche intrinsèque 7 et d'autre part le contact électrique 3.

La forme, vue de dessus, de la couche de contact électrique 3 est celle montrée sur les figures 2 ou 3.

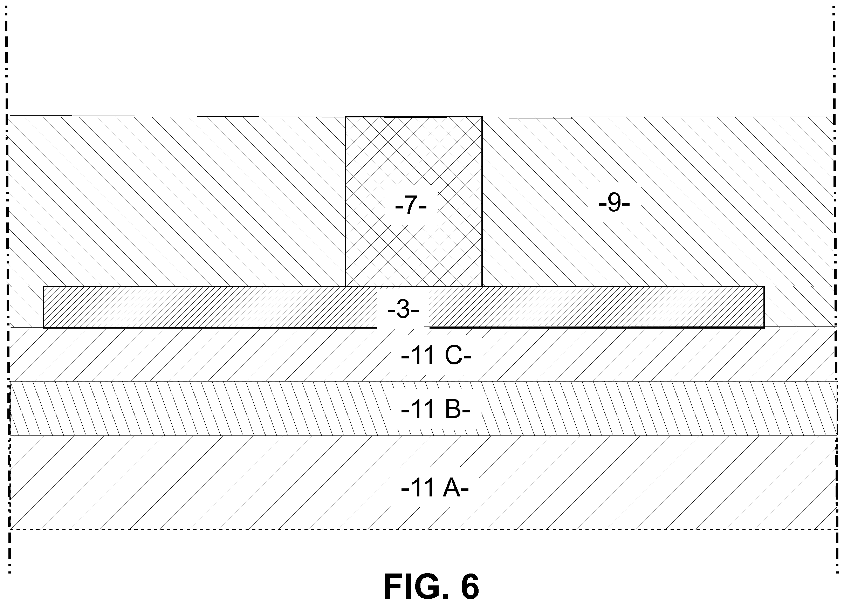

Ensuite, lors d'une troisième étape montrée à la figure 6, aussi bien le plot 7 que le couche de contact électrique 3 sont encapsulées dans une couche d'oxyde de passivation 9. Après le dépôt de cette couche de passivation 9, on effectue une étape d'aplanissement par enlèvement de matière (« rabot ») pour obtenir une surface plane pour la couche 9 et la face supérieure du plot de Germanium 7.

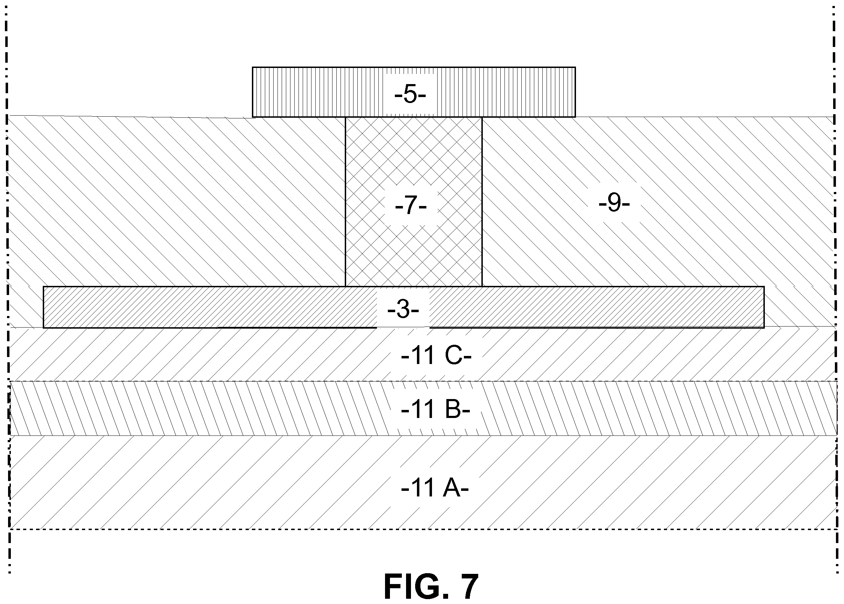

Puis, comme montré sur la figure 7, on réalise un dépôt pleine plaque d'une couche de Si dopé n+ d'une épaisseur d'environ 200nm et on enlève ensuite le surplus périphérique par lithographie et gravure pour former la couche de contact 5.

La forme, vue de dessus, de la couche de contact électrique 5 est celle montrée sur les figures 2 ou 3.

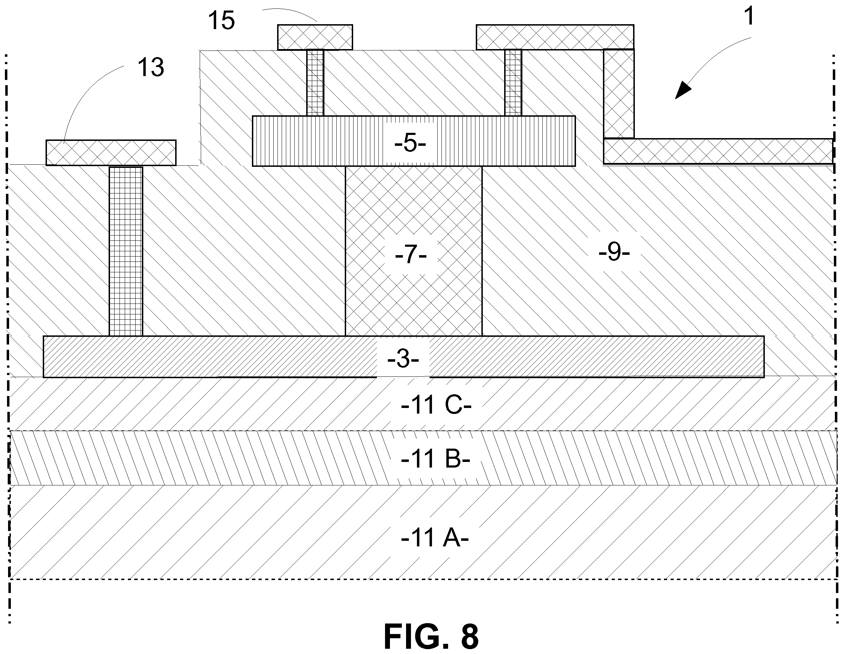

Enfin, comme montré sur la figure 8, on dépose une couche d'oxyde de passivation au-dessus de la couche de contact 5 pour encapsuler celle-ci. Une étape d'aplanissement par enlèvement de matière est également réalisée.

Puis on ménage dans la couche d'oxyde de passivation 9 des ouvertures pour réaliser les contacts métalliques 13 et 15 comme décrit ci-dessus, par métallisation, lithographie et gravure.

En fonction de l'épaisseur de la couche intrinsèque 7, on obtient par exemple une bande passante de 100GHz pour une épaisseur de Germanium de 1µm et de 50GHz pour une épaisseur de 2µm.

## Revendications

1. Récepteur optique semi-conducteur à structure PIN (1) comprenant comme couches de semiconducteur une première couche de contact (3) et une seconde couche de contact (5) ainsi qu'une couche intrinsèque (7) sous forme de plot disposée entre la première couche de contact électrique (3) et la seconde couche de contact électrique (5), les première et seconde couches de contact (3,5) ayant dans un plan perpendiculaire à l'axe du plot des dimensions supérieures à la section transversale du plot (7), caractérisé en que la première et la seconde couche de contact électrique (3,5) présentent respectivement une étendue allongée et sont décalés angulairement l'une par rapport à l'autre pour minimiser les surfaces en regard des deux couches de contact électrique (3,5).

2. Récepteur selon la revendication 1, **caractérisé en ce que** la première couche de contact électrique (3) présente une forme rectangulaire.

3. Récepteur selon la revendication 2, **caractérisé en ce que** la première couche de contact électrique (3) présente une forme rectangulaire arrondie.

4. Récepteur selon l'une quelconque des revendications 1 à 3, **caractérisé en ce que** la deuxième couche de contact (5) présente une forme rectangulaire.

5. Récepteur selon la revendication 4, **caractérisé en ce que** la deuxième couche de contact (5) présente une forme rectangulaire arrondie.

6. Récepteur selon l'une quelconque des revendications 1 à 3, **caractérisé en ce que** la deuxième couche de contact (5) présente une forme circulaire centrale avec des lobes latéraux.

7. Récepteur selon la revendication 6, **caractérisé en ce que** la forme circulaire centrale de la deuxième couche de contact (5) possède un diamètre légèrement supérieur au diamètre du plot (7).

8. Récepteur selon l'une quelconque des revendications 1 à 7, **caractérisé en ce que** le décalage des axes longitudinaux des deux couches de contact (3,5) est de 90°.

9. Récepteur selon l'une quelconque des revendications 1 à 8, **caractérisé en ce que** la couche intrinsèque (7) est réalisée en Germanium, en InGaAs ou en InP.

10. Récepteur selon l'une quelconque des revendications 1 à 9, **caractérisé en ce que** la couche intrinsèque (7) possède une épaisseur comprise entre 1µm et 2µm.

11. Récepteur selon l'une quelconque des revendications 1 à 10, **caractérisé en ce que** le plot de la couche intrinsèque (7) possède une forme cylindrique.

12. Récepteur selon l'une quelconque des revendications 1 à 10, **caractérisé en ce que** le plot de la couche intrinsèque (7) possède une forme tronconique.

13. Récepteur selon l'une quelconque des revendications 1 à 12, **caractérisé en ce que** l'épaisseur des couches de contact électrique (3,5) est comprise entre 200nm et 600nm.

14. Récepteur selon l'une quelconque des revendications 1 à 13, **caractérisé en ce que** les couches de contact électrique sont réalisées en silicium dopé, en InGaAs dopé ou en InP dopé.

## Patentansprüche

1. Optischer Halbleiterempfänger mit PIN-Struktur (1), umfassend als Halbleiterschichten eine erste Kontaktschicht (3) und eine zweite Kontaktschicht (5) sowie eine intrinsische Schicht (7) in Form von einem Stift, die zwischen der ersten elektrischen Kontaktschicht (3) und der zweiten elektrischen Kontaktschicht (5) angeordnet ist, wobei die erste und zweite Kontaktschicht (3, 5) in einer Ebene senkrecht zur Achse des Kontaktplättchens Abmessungen aufweisen, die größer als der Querschnitt des Stiftes (7) sind, **dadurch gekennzeichnet, dass** die erste und die zweite elektrische Kontaktschicht (3, 5) jeweils eine längliche Ausdehnung aufweisen und winkelversetzt voneinander sind, um die Flächen, die den zwei elektrischen Kontaktschichten (3, 5) zugewandt sind, zu minimieren.

2. Empfänger nach Anspruch 1, **dadurch gekennzeichnet, dass** die erste elektrische Kontaktschicht (3) eine rechteckige Form aufweist.

3. Empfänger nach Anspruch 2, **dadurch gekennzeichnet, dass** die erste elektrische Kontaktschicht (3) eine abgerundete rechteckige Form aufweist.

4. Empfänger nach einem der Ansprüche 1 bis 3, **dadurch gekennzeichnet, dass** die zweite Kontaktschicht (5) eine rechteckige Form aufweist.

5. Empfänger nach Anspruch 4, **dadurch gekennzeichnet, dass** die zweite Kontaktschicht (5) eine abgerundete rechteckige Form aufweist.

6. Empfänger nach einem der Ansprüche 1 bis 3, **dadurch gekennzeichnet, dass** die zweite Kontaktschicht (5) eine zentrale kreisförmige Form mit Seitenkeulen aufweist.

7. Empfänger nach Anspruch 6, **dadurch gekennzeichnet, dass** die zentrale kreisförmige Form der zweiten Kontaktschicht (5) einen Durchmesser besitzt, der etwas größer als der Durchmesser des Stiftes (7) ist.

8. Empfänger nach einem der Ansprüche 1 bis 7, **dadurch gekennzeichnet, dass** der Versatz der Längsachsen der zwei Kontaktschichten (3, 5) 90° beträgt.

9. Empfänger nach einem der Ansprüche 1 bis 8, **dadurch gekennzeichnet, dass** die intrinsische Schicht (7) aus Germanium, aus InGaAs oder aus InP hergestellt ist.

10. Empfänger nach einem der Ansprüche 1 bis 9, **dadurch gekennzeichnet, dass** die intrinsische Schicht (7) eine Dicke zwischen 1 µm und 2 µm besitzt.

11. Empfänger nach einem der Ansprüche 1 bis 10, **dadurch gekennzeichnet, dass** der Stift der intrinsischen Schicht (7) eine zylindrische Form besitzt.

12. Empfänger nach einem der Ansprüche 1 bis 10, **dadurch gekennzeichnet, dass** der Stift der intrinsischen Schicht (7) eine kegelstumpfförmige Form besitzt.

13. Empfänger nach einem der Ansprüche 1 bis 12, **dadurch gekennzeichnet, dass** die Dicke der elektrischen Kontaktschichten (3, 5) zwischen 200 nm et 600 nm beträgt.

14. Empfänger nach einem der Ansprüche 1 bis 13, **dadurch gekennzeichnet, dass** die elektrischen Kontaktschichten aus dotiertem Silizium, aus dotiertem InGaAs oder aus dotiertem InP hergestellt sind.

## Claims

1. PIN structure semiconductor optical receiver (1) comprising as semiconductor layers a first contact layer (3), a second contact layer (5) and an intrinsic layer (7) in the form of a stud disposed between the first electrical contact layer (3) and the second electrical contact layer (5), the first and second contact layers (3, 5) having dimensions in a plane perpendicular to the axis of the stud greater than the cross section of the stud (7), **characterized in that** the first and second electrical contact layers (3, 5) are of elongate shape and are offset angularly relative to each other to minimize the facing areas of the two electrical contact layers (3, 5).

2. Receiver according to Claim 1, **characterized in that** the first electrical contact layer (3) has a rectangular shape.

3. Receiver according to Claim 2, **characterized in that** the first electrical contact layer (3) has a rectangular shape with rounded corners.

4. Receiver according to any one of Claims 1 to 3, **characterized in that** the second contact layer (5) has a rectangular shape.

5. Receiver according to Claim 4, **characterized in that** the second contact layer (5) has a rectangular shape with rounded corners.

6. Receiver according to any one of Claims 1 to 3, **characterized in that** the second contact layer (5) has a circular shape at the centre with lateral lobes.

7. Receiver according to Claim 6, **characterized in that** the circular shape at the centre of the second contact layer (5) has a diameter slightly greater than the diameter of the stud (7).

8. Receiver according to any one of Claims 1 to 7, **characterized in that** the offset of the longitudinal axes of the two contact layers (3, 5) is 90°.

9. Receiver according to any one of Claims 1 to 8, **characterized in that** the intrinsic layer (7) is produced in germanium, InGaAs or InP.

10. Receiver according to any one of Claims 1 to 9, **characterized in that** the intrinsic layer (7) has a thickness between 1 µm and 2 µm.

11. Receiver according to any one of Claims 1 to 10, **characterized in that** the stud of the intrinsic layer (7) has a cylindrical shape.

12. Receiver according to any one of Claims 1 to 10, **characterized in that** the stud of the intrinsic layer (7) has a frustoconical shape.

13. Receiver according to any one of Claims 1 to 12, **characterized in that** the thickness of the electrical contact layers (3, 5) is between 200 nm and 600 nm.

14. Receiver according to any one of Claims 1 to 13, **characterized in that** the electrical contact layers are produced in doped silicon, doped InGaAs or doped InP.
